# EUROPEAN PATENT APPLICATION

(11) **EP 4 654 762 A1**
(43) Date of publication of application: **26.11.2025**
(21) Application number: 24209775.6
(22) Date of filing: 30.10.2024
(51) Int. Cl.: H05K 5/00, H05K 7/14, H05K 9/00

(54) **FIXING CONNECTION ASSEMBLY, ELECTRONIC DEVICE, AND ELECTRIC POWER SYSTEM**

(30) Priority: 24.05.2024 CN 202421164278 U
(71) Applicant: Sungrow (Shanghai) Co., Ltd., Shanghai 201203 (CN)
(72) Inventor: LI, Feng, Shanghai, 201203 (CN); YU, Haiyang, Shanghai, 201203 (CN); SHENG, Guodong, Shanghai, 201203 (CN)
(74) Representative: Epping - Hermann - Fischer

(57) **Abstract**

A fixing connection assembly, an electronic device, and an electric power system are provided, which relate to the technical field of electrical technology. In the fixing connection assembly, a limiting structure includes an insulating seat and a limiting member, and the insulating seat is provided with an accommodation cavity and a first hole in communication with the accommodation cavity. The limiting member is accommodated inside the accommodation cavity. The insulating seat is configured to be arranged at a second hole of an electrical structure. A first connector is configured to pass through a third hole of a to-be-connected structure, the second hole, and the first hole. One end of the first connector is connected to the limiting member, and the other end of the first connector is connected to the to-be-connected structure at the third hole, such that a position of the electrical structure relative to a position of the to-be-connected structure is fixed. The to-be-connected structure includes a first housing, and the electrical structure is located inside a mounting cavity of the first housing. At least an inner surface of the first housing is insulated from the electrical structure. The electrical structure and the to-be-connected structure can be reliably connected to each other, and a leakage conductive path of the electrical structure formed by a fixing connection structure can be avoided, thereby reducing safety hazards.

## Description

### FIELD

The present application relates to the technical field of electrical technology, and in particular to a fixing connection assembly, an electronic device and an electric power system.

### BACKGROUND

Some electronic devices, such as an inverter and a power optimizer, generally have a housing structure and an electrical structure arranged inside the housing structure, such as a circuit board. In general, the electrical structure is fixedly connected to the housing structure through a screw connection structure. In order to ensure the stability of the connection between the electrical structure and the housing structure, a screw and a nut are generally made of metal. In this case, the electronic device is expected to be grounded for personnel safety, device safety, and electrostatic protection.

The electrical structure may fail to be grounded due to maintenance, aging, damage, or improper mounting of the device. In addition, some miniaturized devices are not provided with any grounding apparatus. In these cases, the electrical structure easily forms a conductive leakage path through the screw connection structure, which further leads to safety hazards. In other cases, the screw and the nut are insulators, which may affect the reliability of the screw connection structure and the service life of the connection structure.

### SUMMARY

An object of the present application is to solve the problem of how to meet both the mounting reliability requirement and the conductive safety requirement of an electrical structure in the conventional technology.

To solve at least one aspect of the above problem, in a first aspect, a fixing connection assembly is provided according to the present application, including a limiting structure and a first connector. The limiting structure includes an insulating seat and a limiting member, and the insulating seat is provided with an accommodation cavity and a first hole in communication with the accommodation cavity. The limiting member is accommodated in the accommodation cavity. The insulating seat is configured to be arranged at a second hole of an electrical structure. The first connector is configured to pass through a third hole of a to-be-connected structure, the second hole, and the first hole. The first connector has one end connected to the limiting member and the other end connected to the to-be-connected structure at the third hole, such that a position of the electrical structure relative to a position of the to-be-connected structure is fixed. The to-be-connected structure includes a first housing, the electrical structure is located in a mounting cavity of the first housing, and at least an inner surface of the first housing is insulated from the electrical structure.

In an embodiment, the limiting member is provided with a fourth hole, and a position of the fourth hole is in correspondence to a position of the first hole when the limiting member is accommodated in the accommodation cavity, and the first connector is configured to be connected to the limiting member at the fourth hole.

In an embodiment, the first connector is a threaded connector, and the threaded connector passes through the third hole, the second hole, and the first hole from an outer side of the first housing towards an inner side of the first housing and is threadedly connected to the fourth hole; or
the first connector is a fixing block connector, the fixing block connector includes a fixing column and fixing blocks at two ends of the fixing column, the fixing column passes through the third hole, the second hole, the first hole, and the fourth hole, and the fixing blocks at the two ends of the fixing column respectively abut against an end face of the third hole and an end face of the fourth hole facing away from each other.

In an embodiment, the limiting member is detachably connected to the insulating seat in a limited manner.

In an embodiment, a first engagement structure is provided between the limiting member and the insulating seat, and when the limiting member is accommodated in the accommodation cavity, the limiting member and the insulating seat are connected to each other through the first engagement structure; and/or
the insulating seat is provided with a limiting guide groove, a predetermined angle is formed between an extension direction of the limiting guide groove and a depth direction of the first hole, an end of the limiting guide groove is in communication with the first hole to form the accommodation cavity, and the limiting member is movably connected to the limiting guide groove in the extension direction of the limiting guide groove.

In an embodiment, the first engagement structure includes a first engagement portion and a second engagement portion, and the first engagement portion and the second engagement portion are respectively formed on the limiting member and the insulating seat; and
in a case that the first engagement structure is provided between the limiting member and the insulating seat and the insulating seat is provided with the limiting guide groove, the second engagement portion is formed on a groove wall of the limiting guide groove.

In an embodiment, a first groove wall of the limiting guide groove is provided with a notch portion, a remaining portion of the first groove wall is formed with an elastic column through the arrangement of the notch portion, and the second engagement portion is formed at a free end of the elastic column.

In an embodiment, an extension direction of the elastic column is the same as the extension direction of the limiting guide groove, and an end of the elastic column close to the first hole is the free end; and/or
in a depth direction of the third hole, the first groove wall is a groove wall of the limiting guide groove away from the third hole, and the notch portion is arranged to penetrate the first groove wall in a direction away from the third hole.

In an embodiment, the limiting member and the insulating seat are connected to each other to form an integrated structure.

In an embodiment, in the depth direction of the third hole, at least part of the insulating seat is located on a side of the electrical structure away from the third hole, and abuts against the electrical structure on the side of the electrical structure away from the third hole; and/or
the insulating seat is provided with a guide column, the guide column is at least inserted into the second hole of the second hole and the third hole, and the first hole is formed in the guide column; and/or
the insulating seat and the electrical structure are connected to each other through a second engagement structure to limit a movement of the insulating seat relative to the electrical structure in at least one direction.

In an embodiment, the insulating seat is provided with the guide column, a cross-sectional shape of a portion of the guide column corresponding to the second hole and a cross-sectional shape of the second hole are matched with each other and are non-centrosymmetric; and/or
in a case that the insulating seat is provided with the guide column and the guide column is inserted into the third hole, a cross-sectional shape of a portion of the guide column corresponding to the third hole and a cross-sectional shape of the third hole are matched with each other and are non-centrosymmetric; and/or
in a case that the insulating seat is provided with the guide column and the insulating seat is connected to the electrical structure through the second engagement structure, the second engagement structure includes a third engagement portion provided on the insulating seat, and the third engagement portion is located on the guide column.

In an embodiment, the to-be-connected structure includes a radiator, and the radiator is located on the outer side of the first housing; and/or
the electrical structure includes a circuit board; and/or
the first housing is made of an insulative material; and/or
the first housing has an opening, a second housing covers the opening, the first housing is connected to the second housing through at least one of a third engagement structure and a second connector, the second housing is provided with a fifth hole configured to be connected to the second connector, and the fifth hole is any one of a through hole and a blind hole.

In a second aspect, an electronic device is provided according to the present application, including an electrical structure, a to-be-connected structure, and the fixing connection assembly described above. The insulating seat of the limiting structure of the fixing connection assembly is configured to be arranged at a second hole of the electrical structure, and the first connector of the fixing connection assembly is configured to pass through a third hole of the to-be-connected structure, the second hole, and the first hole of the insulating seat. The first connector has one end connected to the limiting member of the limiting structure and the other end connected to the to-be-connected structure at the third hole, so that the position of the electrical structure relative to the position of the to-be-connected structure is fixed. The to-be-connected structure includes a first housing, the electrical structure is located in a mounting cavity of the first housing, and at least an inner surface of the first housing is insulated from the electrical structure.

In a third aspect, an electric power system is provided according to the present application, including the fixing connection assembly described above, or including the electronic device described above.

Compared with the conventional technology, in the fixing connection assembly, the electronic device, and the electric power system according to the present application, the limiting member is accommodated inside the accommodation cavity of the insulating seat, and the insulating seat has the first hole in communication with the accommodation cavity. When the insulating seat of the limiting structure is arranged at the second hole of the electrical structure and the electrical structure is arranged at a proper position inside the first housing of the to-be-connected structure, the positions of the first hole of the insulating seat, the second hole of the electrical structure, and the third hole of the to-be-connected structure correspond to each other in a predetermined direction, such as in a vertical direction. The first connector is inserted into the third hole, the second hole, and the first hole, one end of the first connector is connected to the limiting member, and the other end of the first connector is connected to the to-be-connected structure at the third hole, so that the relative position of the electrical structure and the to-be-connected structure in the vertical direction can be fixed by the fixing connection assembly. Moreover, the limiting member is not in direct contact with the electrical structure, but is connected to the electrical structure through the insulating seat, thereby achieving insulation between the limiting member and the electrical structure, and avoiding direct contact between the electrical structure and the limiting member and the formation of a conductive path. The requirement of the "safety distance" between the electrical structure and the limiting member can be satisfied by providing the insulating seat. Furthermore, at least the inner surface of the first housing is insulated from the electrical structure, for example, the first housing is an insulating housing, so that the electrical structure can be prevented from forming a conductive path through the to-be-connected structure (such as the first housing), the first connector, and the limiting member. In summary, according to the present application, the electrical structure and the to-be-connected structure can be reliably connected to each other. For example, both the first connector and the limiting member may be made of metal. The insulation of the electrical structure can be ensured on the basis of fixing the electrical structure inside the first housing. That is, the electrical structure is ensured to be insulated from the fixing connection assembly, and the formation of a leakage conductive path of the electrical structure due to the arrangement of the fixing connection assembly can be avoided, thereby reducing safety hazards. Particularly, if the device fails to be grounded or is even not grounded, the insulation of the electrical structure can still be ensured to some degree, thereby improving the safety of the electrical conduction. According to the present application, both the mounting reliability requirement and the conductive safety requirement of the electrical structure can be satisfied, and the structure is simple and the practicability is high.

### BRIEF DESCRIPTION OF THE DRAWINGS

FIG. 1 is a schematic sectional view of a fixing connection assembly according to a first embodiment of the present application;
FIG. 2 is an enlarged view of a portion A in FIG. 1;
FIG. 3 is a schematic view showing a structure where a limiting member is arranged in an accommodation cavity at an end of a limiting guide groove, according to the first embodiment of the present application;
FIG. 4 is another schematic structural view of the limiting structure in FIG. 3;
FIG. 5 is another schematic view show the structure where the limiting member is arranged in the limiting guide groove, according to the first embodiment of the present application;
FIG. 6 is a schematic structural view of an electronic device according to an embodiment of the present application;
FIG. 7 is a schematic view showing a structure where a limiting member is arranged in an accommodation cavity at an end of a limiting guide groove, according to a second embodiment of the present application;
FIG. 8 is a schematic view showing a structure where a first engagement structure is provided between the limiting member and an insulating seat, according to the second embodiment of the present application;
FIG. 9 is a schematic view showing a structure where a guide column of an insulating seat is inserted into a second hole 31, according to a third embodiment of the present application;
FIG. 10 is a schematic view showing a structure where an insulating seat and an electrical structure are connected through a second engagement structure, according to a fourth embodiment of the present application; and
FIG. 11 is a schematic view showing a structure where cross-sectional shapes of a guide column corresponding to a second hole and a third hole are both non-centrosymmetric, according to a fifth embodiment of the present application.

**Reference numerals:**

| | | | |
|---|---|---|---|
| 1 | limiting structure, | 11 | insulating seat, |
| 111 | accommodation cavity | 112 | first hole, |
| 113 | limiting guide groove, | 114 | notch portion, |
| 115 | guide column, | 1151 | first protrusion, |
| 12 | limiting member, | 121 | fourth hole, |
| 2 | first connector, | 3 | electrical structure, |
| 31 | second hole, | 4 | to-be-connected structure, |
| 41 | first housing, | 411 | mounting cavity, |
| 421 | opening, | 413 | support column, |
| 414 | predetermined plate, | 42 | radiator, |
| 421 | base, | 422 | fin, |
| 43 | third hole, | 5 | second housing, |
| 6 | first engagement structure, | 61 | first engagement portion, |
| 62 | second engagement portion, | 63 | elastic column, |
| 7 | second engagement structure, | 71 | third engagement portion. |

### DETAILED DESCRIPTION OF THE EMBODIMENTS

In order to make the objects, features and advantages of the present application more obvious and easy to understand, specific embodiments of the present application are described in detail below in conjunction with the accompany drawings.

In the description of the present application, it should be noted that, unless otherwise clearly specified or limited, the terms "mount", "connect with", "connect to" should be understood in a broad sense. For example, the connection may be in a fixed manner, a detachable manner, or an integral manner, and the connection may be a direct connection or an indirect connection through an intermediate medium. For those skilled in the art, the specific meanings of the terms hereinabove in the present application can be understood according to practice.

In the description of this specification, descriptions of the terms, such as "embodiment", "an embodiment", "some implementations", "exemplarily" and "an implementation", mean that specific features, structures, materials or characteristics described in conjunction with the embodiment or implementation are included in at least one embodiment or implementation of the present application. In this specification, schematic expressions of the above terms do not necessarily refer to the same embodiment or implementation. Furthermore, the specific features, structures, materials or characteristics described may be combined in any one or more embodiments or implementations in a suitable manner.

The terms such as "first", "second" and the like are used for descriptive purposes only, and should not be understood as indicating or implying relative importance, or implicitly indicating the number of technical features referred to. In this way, the feature defined by the term "first" or "second" may explicitly or implicitly include at least one such feature.

In the drawings, the Z-axis denotes a vertical direction, i.e. an up-down direction, where a positive direction (i.e. a direction indicated by an arrow of the Z-axis) of the Z-axis indicates an upper side, and a negative direction of the Z-axis indicates a lower side. The X-axis denotes a front-rear direction, where a positive direction (i.e. a direction indicated by an arrow of the X-axis) of the X-axis indicates a front side, and a negative direction of the X-axis indicates a rear side. The Y-axis denotes a horizontal direction, which is referred to as a left-right direction, where a positive direction (i.e. a direction indicated by an arrow of the Y-axis) of the Y-axis indicates a right side, and a negative direction of the Y-axis indicates a left side. It should also be noted that, the meanings of the Z-axis, Y-axis and X-axis described above are merely for the convenience of describing the present application and simplifying the description, and do not indicate or imply that the device or element referred to must have a particular orientation, or be configured and operated in a particular orientation, which therefore should not be construed as a limitation to the present application.

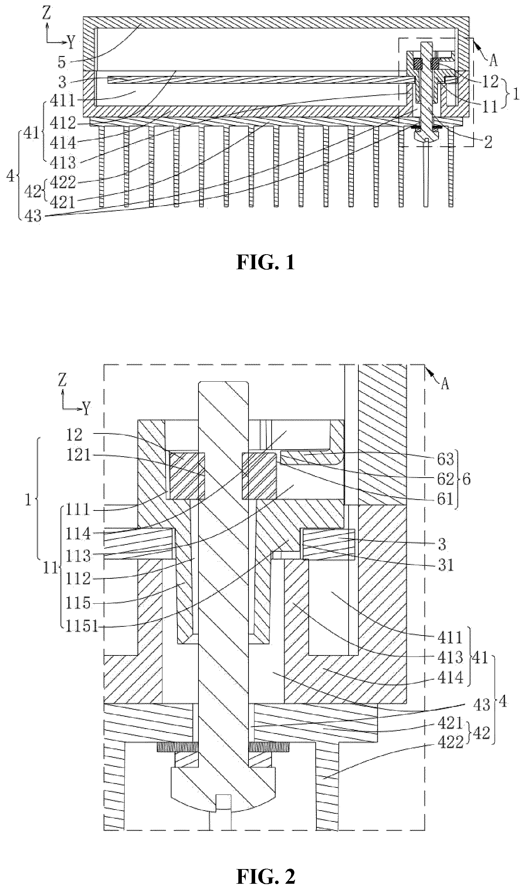

As shown in FIG. 1 and FIG. 2, in a first aspect, a fixing connection assembly is provided according to the present application, including a limiting structure 1 and a first connector 2. The limiting structure 1 includes an insulating seat 11 and a limiting member 12. The insulating seat 11 is formed with an accommodation cavity 111 and a first hole 112 in communication with the accommodation cavity 111. The limiting member 12 is accommodated in the accommodation cavity 111. The insulating seat 11 is configured to be arranged at a second hole 31 of an electrical structure 3. The first connector 2 is configured to pass through a third hole 43 of a to-be-connected structure 4, the second hole 31, and the first hole 112. One end of the first connector 2 is connected to the limiting member 12, and the other end of the first connector 2 is connected to the to-be-connected structure 4 at the third hole 43. Thus, the relative position of the electrical structure 3 and the to-be-connected structure 4 are fixed. The to-be-connected structure 4 includes a first housing 41. The electrical structure 3 is located in a mounting cavity 411 of the first housing 41, and at least an inner surface of the first housing 41 is insulated from the electrical structure 3.

In the embodiment, the fixing connection assembly is used for fixation of relative positions of multiple components in a predetermined direction, such as in the direction of the Z-axis in the drawings. The first housing 41 has the mounting cavity 411, and a top portion of the mounting cavity 411 has an opening 412. A second housing 5 described hereinafter covers the opening 412. The first housing 41 and the second housing 5 together from a relatively complete housing structure to protect the electrical structure 3. The specific protection level may be determined according to actual needs.

In the embodiment, both the first housing 41 and the second housing 5 are insulating housings. That is, each of the first housing 41 and the second housing 5 is made of an insulative material, such as plastic, thereby achieving insulation between the first housing 41 and the electrical structure 3.

It should be understood that, the present application is not limited to this arrangement. For example, on the basis of satisfying a corresponding "safety distance", an insulating pad may be provided between a predetermined plate 414 of the first housing 41 and the electrical structure 3, and the insulating pad may be understood by referring to a support column 413 described hereinafter, which is not described in detail herein. The "safety distance" (also called a safe spacing, an electrical clearance, or a creepage distance) refers to a minimum electrical insulation distance specified to prevent electrical accidents, such as an electric shock, an arc discharge, short-circuit, a fire caused by an electric spark and the like.

In the limiting structure 1, the limiting member 12 configured to be connected to the first connector 2 is arranged in the accommodation cavity 111 of the insulating seat 11. The limiting member 12 is connected to the electrical structure 3 through the insulating seat 11, and the insulating seat 11 can realize the insulation between the limiting member 12 and the electrical structure 3. With such arrangement, the requirement of the "safety distance" between the limiting member 12 and the electrical structure 3 can be satisfied by using the insulating seat 11.

After the first connector 2 is connected to the limiting member 12 and the to-be-connected structure 4, the position of the electrical structure 3 relative to the position of the to-be-connected structure 4 in the up-down direction can be fixed, and the electrical structure 3 and the to-be-connected structure 4 are prevented from being separated from each other in the up-down direction. Based on this, a way in which the insulating seat 11 is arranged at the second hole 31 of the electrical structure 3 is not limited, which is exemplarily described hereinafter.

The limiting member 12 is accommodated in the accommodation cavity 111 of the insulating seat 11, and the insulating seat 11 has the first hole 112 in communication with the accommodation cavity 111. When the insulating seat 11 of the limiting structure 1 is arranged at the second hole 31 of the electrical structure 3 and the electrical structure 3 is arranged at a suitable position inside the first housing 41 of the to-be-connected structure 4, positions of the first hole 112 of the insulating seat 11, the second hole 31 of the electrical structure 3, and the third hole 43 of the to-be-connected structure 4 can correspond to each other in the predetermined direction, such as the up-down direction. The first connector 2 passes through the third hole 43, the second hole 31, and the first hole 112, one end of the first connector 2 is connected to the limiting member 12, and the other end of the first connector 2 is connected to the to-be-connected structure 4 at the third hole 43, so that the relative position of the electrical structure 3 and the to-be-connected structure 4 along the up-down direction can be fixed by the fixing connection assembly. Moreover, the limiting member 12 is not in direct contact with the electrical structure 3, but is connected to the electrical structure 3 through the insulating seat 11, thereby achieving insulation between the limiting member 12 and the electrical structure 3, and preventing the electrical structure 3 from directly contacting the limiting member 12 and forming a conductive path. Thus, the requirement of the "safety distance" between the electrical structure 3 and the limiting member 12 is satisfied by providing the insulating seat 11. Furthermore, at least the inner surface of the first housing 41 is insulated from the electrical structure 3, for example, the first housing 41 is an insulating housing, so that the electrical structure 3 can be prevented from forming a conductive path through the to-be-connected structure 4 (such as the first housing 41), the first connector 2, and the limiting member 12. In summary, according to the present application, the electrical structure 3 and the to-be-connected structure 4 can be reliably connected to each other. For example, both the first connector 2 and the limiting member 12 may be made of metal. The insulation of the electrical structure 3 can be ensured on the basis of fixing the electrical structure 3 inside the first housing 41. That is, the electrical structure 3 is ensured to be insulated from the fixing connection assembly, and the formation of a leakage conductive path of the electrical structure 3 due to the arrangement of the fixing connection assembly can be avoided, thereby reducing safety hazards. Particularly, if the device fails to be grounded or is even not grounded, the insulation of the electrical structure 3 can still be ensured to some degree, thereby improving the safety of the electrical conduction. According to the present application, both the mounting reliability requirement and the conductive safety requirement of the electrical structure 3 can be satisfied, and the structure is simple and the practicability is high.

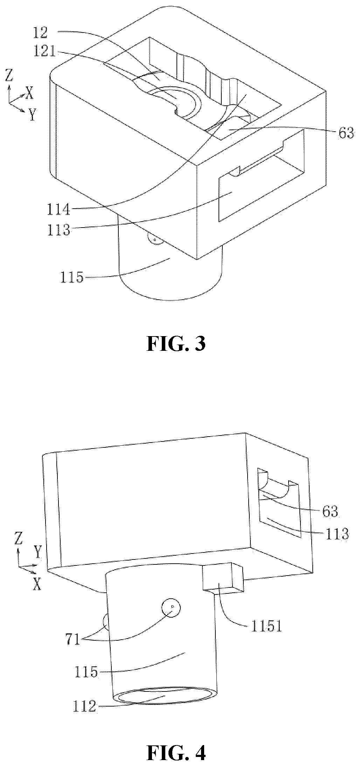

As shown in FIG. 4, in an optional solution of the limiting structure 1, the limiting member 12 is provided with a fourth hole 121. When the limiting member 12 is accommodated inside the accommodation cavity 111, a position of the fourth hole 121 is in correspondence to the position of the first hole 112, and the first connector 2 is configured to be connected to the limiting member 12 at the fourth hole 121.

In an embodiment, when the limiting member 12 is accommodated inside the accommodation cavity 111, the position of the fourth hole 121 is in correspondence to the position of the first hole 112 in the vertical direction, and a lower surface of the limiting member 12 abuts against an inner bottom surface of the accommodation cavity 111 located below. For example, the lower part of the accommodation cavity 111 is in communication with and formed with the first hole 112. It should be understood that, the first hole 112 may penetrate the insulating seat 11 in the vertical direction, that is, the upper part of the accommodation cavity 111 is also in communication with and formed with the first hole 112.

In this way, at least part of an upper end of the first connector 2 extends into the fourth hole 121 and is connected to the limiting member 12. The specific manner of the connection between the first connector 2 and the limiting member 12 is not limited, and is exemplarily described hereinafter, as long as the limiting member 12 limits a downward movement of the first connector 2 when the first connector 2 and the limiting member 12 are connected to each other.

As shown in FIG. 4, in a further solution of the limiting structure 1, the first connector 2 is a threaded connector, and the threaded connector passes through the third hole 43, the second hole 31, and the first hole 112 from an outer side of the first housing 41 towards an inner side of the first housing 41, and is in a threaded connection with the fourth hole 121.

In an embodiment, the threaded connector is a screw. A larger end of the screw abuts against the to-be-connected structure 4 at a lower end face of the third hole 43, and a smaller end of the screw is in a threaded connection with the limiting member 12 at the fourth hole 121. In this case, the limiting member 12 is a nut member.

In this way, the limiting member 12 and the threaded connector respectively employ a nut and a screw in the conventional technology, which is convenient for procurement and low in cost.

Differing from the above solution that the first connector 2 is the threaded connector, in another solution of the limiting structure 1, the first connector 2 is a fixing block connector. The fixing block connector includes a fixing column and fixing blocks at two ends of the fixing column. The fixing column passes through the third hole 43, the second hole 31, the first hole 112, and the fourth hole 121, and the fixing blocks at the two ends of the fixing column respectively abut against an end face of the third hole 43 and an end face of the fourth hole 121 facing away from each other.

In an embodiment, the fixing block at an upper end of the fixing column abuts against an upper end face of the fourth hole 121, and the fixing block at a lower end of the fixing column abuts against the lower end face of the third hole 43. Therefore, the relative position of the electrical structure 3 and the to-be-connected structure 4 in the up-down direction can be fixed through the fixing block connector. This solution is not shown in the drawings, and is not described in detail hereinafter.

It should be understood that, in this case, the limiting member 12 is not necessarily provided with the fourth hole 121. For example, the limiting member 12 may be a limiting block, and a projection of the limiting block in the up-down direction is located on a side of a projection of the first hole 112 in the up-down direction, and the two projections do not overlap with each other.

In an embodiment, the limiting member 12 is detachably connected to the insulating seat 11 in a limited manner.

In an embodiment, when the limiting member 12 is accommodated inside the accommodation cavity 111, the lower surface of the limiting member 12 abuts against the inner bottom surface of the accommodation cavity 111 located below the limiting member 12. Moreover, the insulating seat 11 can prevent the limiting member 12 from being separated from the insulating seat 11 to some extent. For example, the insulating seat 11 at least limits the upward movement of the limiting member 12 and the separation of the limiting member 12 from the insulating seat 11. The specific implementation is exemplarily described hereinafter.

The limiting member 12 is detachably connected to the insulating seat 11 in a limited manner, so that one of the limiting member 12 and the insulating seat 11 can be replaced when necessary. For example, the insulating seat 11 is a plastic member, and the insulating seat 11 can be replaced when the insulating seat 11 is aged or cracked. The limiting member 12 is a nut member, and the nut member can be replaced when the thread of the nut member fails due to disassembly and assembly with the first connector 2 for too many times, which facilitates the modular design and low-cost application of the limiting structure 1.

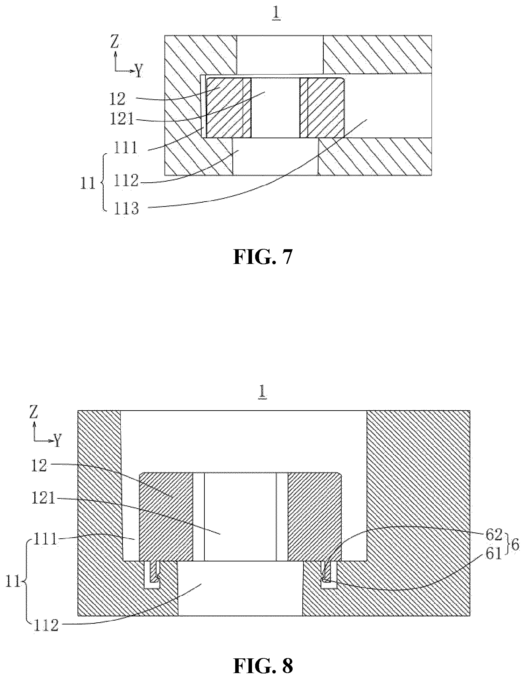

As shown in FIG. 8, in an embodiment, a first engagement structure 6 is provided between the limiting member 12 and the insulating seat 11. In the case that the limiting member 12 is accommodated inside the accommodation cavity 111, the limiting member 12 and the insulating seat 11 are connected through the first engagement structure 6.

In an embodiment, the first engagement structure 6 includes a first engagement portion 61 and a second engagement portion 62, and the first engagement portion 61 and the second engagement portion 62 are respectively formed on the limiting member 12 and the insulating seat 111. In the case that the limiting member 12 is accommodated inside the accommodation cavity 111, the first engagement portion 61 and the second engagement portion 62 are engaged with each other by means of snap-fit connection, thereby preventing the limiting member 12 from falling off from the accommodation cavity 111.

In this way, the relative movement between the limiting member 12 and the insulating seat 11 can be prevented by the first engagement structure 6, thereby ensuring the connection stability of the limiting member 12 and the insulating seat 11.

As shown in FIG. 7, in a further solution of the limiting structure 1, the insulating seat 11 has a limiting guide groove 113. A predetermined angle is formed between an extension direction of the limiting guide groove 113 and a depth direction of the first hole 112. One end of the limiting guide groove 113 is in communication with the first hole 112 to form the accommodation cavity 111, and the limiting member 12 is movably connected to the limiting guide groove 113 in the extension direction of the limiting guide groove 113.

In an embodiment, the extension direction of the limiting guide groove 113 may be perpendicular to the up-down direction. For example, the limiting guide groove 113 may extend along the Y-axis. The arrangement of the limiting guide groove 113 only allows the limiting member 12 to move in the extension direction of the limiting guide groove 113, and does not allow the limiting member 12 to move in other directions, for example, does not allow the limiting member 12 to rotate, thereby reducing the possibility that the limiting member 12 falls from the insulating seat 11.

Further, an end of the limiting guide groove 112 away from the first hole 112 (that is, an end where an opening of the limiting guide groove 113 is located) may be an outer end of the limiting guide groove 113, for example, a right end of the limiting guide groove 112 in the drawings. A distance between the outer end and a right side wall of the first housing 41 may be smaller than a predetermined value, thereby preventing the limiting member 12 from falling from the outer end.

Further, the limiting member 12 may be in a damping sliding connection with the limiting guide groove 113 to prevent the limiting member 12 from easily leaving the accommodation cavity 111.

As shown in FIG. 2 to FIG. 5, it should be understood that, in an embodiment, the first engagement structure 6 is provided between the limiting member 12 and the insulating seat 11, and the insulating seat 11 has the limiting guide groove 113. In this case, the first engagement portion 61 and the second engagement portion 62 are respectively formed on the limiting member 12 and a groove wall of the limiting guide groove 113.

In an embodiment, when the limiting member 12 is sliding from the limiting guide groove 113 towards the accommodation cavity 111, the second engagement portion 62 is located on a moving path of the first engagement portion 61. When the limiting member 12 is located inside the accommodation cavity 111, the second engagement portion 62 and the first engagement portion 61 are locked with each other by means of snap-fit connection. The second engagement portion 62 prevents the limiting member 12 from sliding outwards through the limiting guide groove 113 and being separated from the accommodation cavity 111.

In this case, the mounting reliability of the limiting member 12 in the insulating seat 11 is relatively high, and the insulating seat 11 can achieve good insulation at a periphery of the limiting member 12, so as to satisfy the "safety distance" requirement. The present application is described hereinafter based on this example.

As shown in FIG. 2, FIG. 3, and FIG. 5, in a further solution of the first engagement structure 6, a first groove wall of the limiting guide groove 113 is provided with a notch portion 114. An elastic column 63 is formed on a remaining portion of the first groove wall due to the arrangement of the notch portion 114, and the second engagement portion 62 is formed at a free end of the elastic column 63.

In an embodiment, a fixed end of the elastic column 63 is fixed with respect to a main body portion of the insulating seat 11, and two ends of the elastic column 63 may move relative to each other when subjected to a force.

In this way, due to the elastic performance of the elastic column 63, the relative movement requirements of the locking and unlocking of the second engagement portion 62 and the first engagement portion 61 can be satisfied.

As shown in FIG. 2, FIG. 3, and FIG. 5, further, an extension direction of the elastic column 63 is the same as the extension direction of the limiting guide groove 113, and an end of the elastic column 63 close to the first hole 112 is the free end.

Exemplarily, the second engagement portion 62 is formed on an end face of the end of the elastic column 63 close to the first hole 112. Correspondingly, the first engagement portion 61 is formed on an end face of the limiting member 12 close to the elastic column 63 in the extension direction of the limiting guide groove 113. During the sliding process of the limiting member 12 from right to left, the limiting member 12 presses the elastic column 63, such that the free end of the elastic column 63 is deflected. When the limiting member 12 moves to the accommodation cavity 111, the limiting member 12 is separated from the elastic column 63 and the free end of the elastic column 63 is reset. The second engagement portion 62 is arranged on the moving path of the first engagement portion 61 to limit the rightward movement of the limiting member 12 and prevent the limiting member 12 from being separated from the accommodation cavity 111. In other embodiments, the elastic column 63 may extend in other directions, such as in the direction of the Z-axis or the X-axis, which is not described in detail herein.

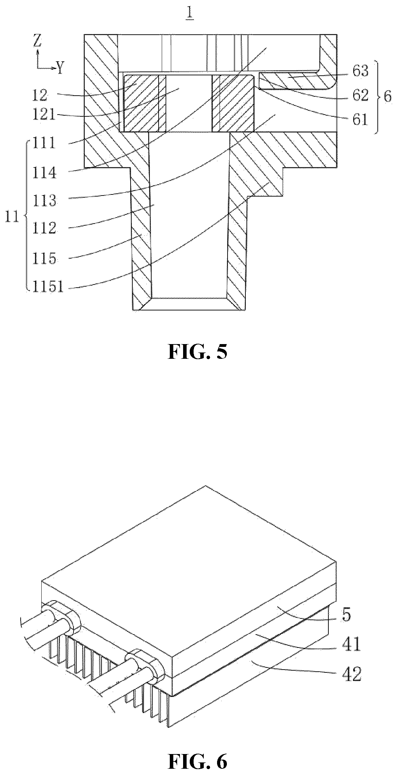

As shown in FIG. 5, further, in a depth direction of the third hole 43, the first groove wall is a groove wall of the limiting guide groove 113 away from the third hole 43, and the notch portion 114 penetrates the first groove wall in a direction away from the third hole 43.

In an embodiment, as shown in FIG. 2, FIG. 3, and FIG. 5, the first groove wall is a groove wall on an upper side of the limiting guide groove 113. The notch portion 114 forms an observation window penetrating the limiting member 12 and the elastic column 63 from above, which can reduce the weight of the insulating seat 11. The structure is simple and the cost is low.

In some cases, the elastic column 63 is further provided with an operation portion. The operation portion is used to apply force to unlock the first engagement structure 6. The operation portion may be provided at the notch portion 114 to facilitate the operation. For example, the operation portion extends upwards and protrudes from an upper end face of the insulating seat 11, which is not described in detail herein.

It should be understood that, differing from the above solution that the limiting member 12 is detachably connected to the insulating seat 11 in a limited manner, in an optional embodiment of the present application, the limiting member 12 and the insulating seat 11 are connected to each other to form an integrated structure.

In an embodiment, the limiting member 12 is a metal member. The integrated structure is formed by injection molding with the limiting member 12 as an insert. That is, the limiting structure 1 is an integrated structure.

In the above embodiment, optionally, in the depth direction of the third hole 43, at least part of the insulating seat 11 is located on a side of the electrical structure 3 away from the third hole 43, and abuts against the electrical structure 3 on the side of the electrical structure 3 away from the third hole 43.

As shown in FIG. 2, the electrical structure 3 includes a circuit board. In the depth direction of the third hole 43, at least part of the insulating seat 11 is located on an upper side of the circuit board, so that the circuit board can prevent the insulating seat 11 from moving downwards. Thus, when the first connector 2 is connected to the limiting member 12 and the to-be-connected structure 4, such as the first housing 41, the first connector 2 applies a downward pressure to the circuit board through the limiting member 12 and the insulating seat 11, such that the circuit board is pressed against the first housing 41.

As shown in FIG. 2, in the above embodiment, optionally, the insulating seat 11 is provided with a guide column 115. The guide column 115 is at least inserted into the second hole 31 of the second hole 31 and the third hole 43, and the first hole 112 is formed in the guide column 115.

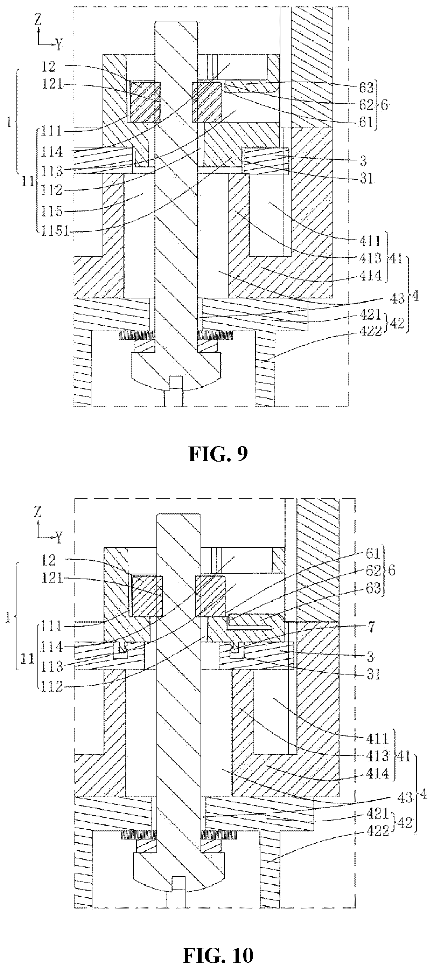

In this case, the first hole 112 penetrates through the guide column 115 along the up-down direction, and is in communication with the accommodation cavity 111. As shown in FIG. 9, the guide column 115 may be inserted only into the second hole 31. Alternatively, as shown in FIG. 2, the guide column 115 may be inserted into the second hole 31 and the third hole 43.

In this way, the position of the insulating seat 11 relative to the position of the electrical structure 3 can be fixed by inserting the guide column 115 into the second hole 31, that is, the position of the limiting structure 1 relative to the position of the electrical structure 3 can be fixed, which facilitates the subsequent connection operation of the first connector 2.

As shown in FIG. 4, further, in a case that the insulating seat 11 is provided with the guide column 115, a cross-sectional shape of a portion of the guide column 115 corresponding to the second hole 31 and a cross-sectional shape of the second hole 31 are matched with each other and are non-centrosymmetric.

As shown in FIG. 2, FIG. 4, and FIG. 5, the portion of the guide column 115 corresponding to the second hole 31 is provided with a first protrusion 1151. By providing the first protrusion 1151, the cross-sectional shape of the portion of the guide column 115 corresponding to the second hole 31 is non-centrosymmetric.

In this way, the guide column 115 can only be inserted into the second hole 31 in a preset posture, and the rotation of the insulating seat 11 relative to the electrical structure 3 in a circumferential direction of the second hole 31is avoided.

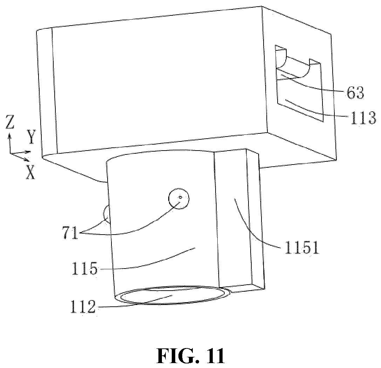

As shown in FIG. 11, further, in a case that the insulating seat 11 is provided with the guide column 115 and the guide column 115 is inserted into the third hole 43, a cross-sectional shape of a portion of the guide column 115 in correspondence to the third hole 43 and a cross-sectional shape of the third hole 43 are matched with each other and are non-centrosymmetric.

In this way, the guide column 115 can only be inserted into the third hole 43 in a preset posture, and the relative rotation of the insulating seat 11 and the electrical structure 3 in a circumferential direction of the third hole 43 is avoided.

FIG. 11 shows a case that the cross-sectional shapes of the guide column 115 at various locations are non-centrosymmetric. In this way, the rotation of the insulating seat 11 relative to the electrical structure 3 in the circumferential direction of the second hole 31 can be avoided, and the rotation of the insulating seat 11 relative to the electrical structure 3 in the circumferential direction of the third hole 43 can be avoided.

As shown in FIG. 10, in an embodiment, the insulating seat 11 and the electrical structure 3 are connected through a second engagement structure 7, to limit a movement of the insulating seat 11 with respect to the electrical structure 3 in at least one direction.

The second engagement structure 7 may include a third engagement portion 71 and a fourth engagement portion, which are respectively provided on the insulating seat 11 and the electrical structure 3. In the case that the insulating seat 11 is arranged at the second hole 31, the third engagement portion 71 and the fourth engagement portion are engaged with each other by means of snap-fit connection.

As shown in FIG. 4, further, in a case that the insulating seat 11 is provided with the guide column 115 and the insulating seat 11 is connected to the electrical structure 3 through the second engagement structure 7, the third engagement portion 71 is located on the guide column 115.

As shown in FIG. 3 and FIG. 4, exemplarily, the third engagement portion 71 may be a retractable structure, such as a retractable bead, and the fourth engagement portion is a groove formed on an inner wall of the second hole 31. When the retractable bead moves to the groove, the retractable bead enters the groove to realize the engagement of the retractable bead and the groove. The movement of the insulating seat 11 relative to the electrical structure 3 in the vertical direction can be limited, and the movement of the insulating seat 11 relative to the electrical structure 3 in the circumferential direction of the second hole 31 can also be limited.

As shown in FIG. 1 and FIG. 2, in the above embodiments, optionally, the to-be-connected structure 4 further includes a radiator 42, and the radiator 42 is located on an outer side of the first housing 41.

In an embodiment, the radiator 42 includes a base 421 and a fin 422 provided below the base 421. The base 421 is attached to the predetermined plate 414 of the first housing 41, and the predetermined plate 414 is further provided with a support column 413 for supporting the electrical structure 3. The third hole 43 is formed in the base 421, the predetermined plate 414, and the support column 413.

In this way, by providing the fixing connection assembly, the radiator 42, the first housing 41, and the electrical structure 3 can be connected, thereby reducing the number and the complexity of the connection structures between multiple components. Moreover, in some cases, the connection of the radiator 42, the first housing 41, and the electrical structure 3 can be implemented from an outer side of the heat dissipation structure. The radiator 42 is generally arranged on the back of the housing structure of an entire electronic device, that is, the predetermined plate 414 is a back plate of the electronic device, where the back plate is usually a plate on a side of the electronic device away from a user. Therefore, the exposure of the first connector 2 can be avoided, and the neatness and aesthetics of a front side of the electronic device are improved.

In an embodiment, the first housing 41 has an opening 412, and a second housing 5 covers the opening 412. The first housing 41 and the second housing 5 are connected to each other through at least one of a third engagement structure and a second connector. The second housing 5 has a fifth hole configured to be connected to the second connector, and the fifth hole is any one of a through hole and a blind hole.

For example, the second connector may be a screw. When the screw passes through the first housing 41 from the outer side of the first housing 41 to be connected to the second housing 5, for example, to be connected to the blind hole, the second connector can be prevented from being exposed outside the second housing 5. Moreover, the connection operations of the first connector 2 and the second connector can be performed on a side where the radiator 42 is located, which facilitates the assembling of the entire electronic device and improves the assembling efficiency of the electronic device. For example, during assembling, the opening of the second housing 5 faces upwards, the electrical structure 3 engaged with the limiting structure 1 is arranged inside the second housing 5, and then, the first housing 41 is arranged. Finally, the connection operations of the first connector 2 and the second connector are performed, thereby completing the assembling of the electronic device. The mounting orientation of the assembled electronic device is not limited.

As shown in FIG. 1 to FIG. 6, an electronic device is provided according to another embodiment of the present application, including an electrical structure 3, a to-be-connected structure 4, and the fixing connection assembly described above. An insulating seat 11 of a limiting structure 1 of the fixing connection assembly is configured to be arranged at a second hole 31 of the electrical structure 3, and a first connector 2 of the fixing connection assembly is configured to pass through a third hole 43 of the to-be-connected structure 4, the second hole 31, and a first hole 112 of the insulating seat 11. One end of the first connector 2 is connected to a limiting member 12 of the limiting structure 1, and the other end of the first connector 2 is connected to the to-be-connected structure 4 at the third hole 43, so that the position of the electrical structure 3 relative to the position of the to-be-connected structure 4 is fixed. The to-be-connected structure 4 includes a first housing 41, and the electrical structure 3 is located inside a mounting cavity 411 of the first housing 41. At least an inner surface of the first housing 41 is insulated from the electrical structure 3.

Components of the electronic device, such as the second connector and the second housing 5, are described in the above embodiments, which are not repeated herein. The electronic device may be a power optimizer, an inverter or the like, which is not limited.

An electric power system is provided according to another embodiment of the present application, including the fixing connection assembly described above or including the electronic device described above.

For example, the electric power system may be an inverter system, or a photovoltaic system. Each of the electrical power system and the electronic device has all the beneficial effects of the fixing connection assembly, which is not described in detail herein.

Although the present application is disclosed hereinabove, the protection scope of the present application is not limited thereto. Many variations and modifications may be made by those skilled in the art without departing from the spirit and scope of the present application, and these variations and modifications are deemed to fall into the protection scope of the present application.

## Claims

1. A fixing connection assembly, comprising a limiting structure (1) and a first connector (2), wherein
the limiting structure (1) comprises an insulating seat (11) and a limiting member (12), and the insulating seat (11) is provided with an accommodation cavity (111) and a first hole (112) in communication with the accommodation cavity (111);
the limiting member (12) is accommodated in the accommodation cavity (111), and the insulating seat (11) is configured to be arranged at a second hole (31) of an electrical structure (3);
the first connector (2) is configured to pass through a third hole (43) of a to-be-connected structure (4), the second hole (31), and the first hole (112), the first connector (2) has one end connected to the limiting member (12) and the other end connected to the to-be-connected structure (4) at the third hole (43), such that a position of the electrical structure (3) relative to a position of the to-be-connected structure (4) is fixed; and
the to-be-connected structure (4) comprises a first housing (41), the electrical structure (3) is located in a mounting cavity (411) of the first housing (41), and at least an inner surface of the first housing (41) is insulated from the electrical structure (3).

2. The fixing connection assembly according to claim 1, wherein the limiting member (12) is provided with a fourth hole (121), and a position of the fourth hole (121) is in correspondence to a position of the first hole (112) when the limiting member (12) is accommodated in the accommodation cavity (111), and the first connector (2) is configured to be connected to the limiting member (12) at the fourth hole (121).

3. The fixing connection assembly according to claim 2, wherein
the first connector (2) is a threaded connector, and the threaded connector passes through the third hole (43), the second hole (31), and the first hole (112) from an outer side of the first housing (41) towards an inner side of the first housing (41) and is threadedly connected to the fourth hole (121); or
the first connector (2) is a fixing block connector, the fixing block connector comprises a fixing column, and fixing blocks at two ends of the fixing column, the fixing column passes through the third hole (43), the second hole (31), the first hole (112), and the fourth hole (121), and the fixing blocks at the two ends of the fixing column respectively abut against an end face of the third hole (43) and an end face of the fourth hole (121) facing away from each other.

4. The fixing connection assembly according to claim 2, wherein the limiting member (12) is detachably connected to the insulating seat (11) in a limited manner.

5. The fixing connection assembly according to claim 4, wherein
a first engagement structure (6) is provided between the limiting member (12) and the insulating seat (11), and the limiting member (12) and the insulating seat (11) are connected to each other through the first engagement structure (6) when the limiting member (12) is accommodated in the accommodation cavity (111); and/or
the insulating seat (11) is provided with a limiting guide groove (113), a predetermined angle is formed between an extension direction of the limiting guide groove (113) and a depth direction of the first hole (112), an end of the limiting guide groove (113) is in communication with the first hole (112) to form the accommodation cavity (111), and the limiting member (12) is movably connected to the limiting guide groove (113) in the extension direction of the limiting guide groove (113).

6. The fixing connection assembly according to claim 5, wherein
the first engagement structure (6) comprises a first engagement portion (61) and a second engagement portion (62), and the first engagement portion (61) and the second engagement portion (62) are respectively formed on the limiting member (12) and the insulating seat (11); and
in a case that the first engagement structure (6) is provided between the limiting member (12) and the insulating seat (11) and the insulating seat (11) is provided with the limiting guide groove (113), the second engagement portion (62) is formed on a groove wall of the limiting guide groove (113).

7. The fixing connection assembly according to claim 6, wherein a first groove wall of the limiting guide groove (113) is provided with a notch portion (114), a remaining portion of the first groove wall is formed with an elastic column (63) through the arrangement of the notch portion (114), and the second engagement portion (62) is formed at a free end of the elastic column (63).

8. The fixing connection assembly according to claim 7, wherein
an extension direction of the elastic column (63) is the same as the extension direction of the limiting guide groove (113), and an end of the elastic column (63) close to the first hole (112) is the free end; and/or
in a depth direction of the third hole (43), the first groove wall is a groove wall of the limiting guide groove (113) away from the third hole (43), and the notch portion (114) is arranged to penetrate the first groove wall in a direction away from the third hole (43).

9. The fixing connection assembly according to claim 1, wherein the limiting member (12) and the insulating seat (11) are connected to each other to form an integrated structure.

10. The fixing connection assembly according to any one of claims 1 to 9, wherein
in a depth direction of the third hole (43), at least part of the insulating seat (11) is located on a side of the electrical structure (3) away from the third hole (43), and abuts against the electrical structure (3) on the side of the electrical structure (3) away from the third hole (43); and/or
the insulating seat (11) is provided with a guide column (115), the guide column (115) is at least inserted into the second hole (31) of the second hole (31) and the third hole (43), and the first hole (112) is formed in the guide column (115); and/or
the insulating seat (11) and the electrical structure (3) are connected to each other through a second engagement structure (7) to limit a movement of the insulating seat (11) relative to the electrical structure (3) in at least one direction.

11. The fixing connection assembly according to claim 10, wherein
the insulating seat (11) is provided with the guide column (115), a cross-sectional shape of a portion of the guide column (115) corresponding to the second hole (31) and a cross-sectional shape of the second hole (31) are matched with each other and non-centrosymmetric; and/or
in a case that the insulating seat (11) is provided with the guide column (115) and the guide column (115) is inserted into the third hole (43), a cross-sectional shape of a portion of the guide column (115) corresponding to the third hole (43) and a cross-sectional shape of the third hole (43) are matched with each other and non-centrosymmetric; and/or
in a case that the insulating seat (11) is provided with the guide column (115) and the insulating seat (11) is connected to the electrical structure (3) through the second engagement structure (7), the second engagement structure (7) comprises a third engagement portion (71) provided on the insulating seat (11), and the third engagement portion (71) is located on the guide column (115).

12. The fixing connection assembly according to any one of claims 1 to 9, wherein
the to-be-connected structure (4) further comprises a radiator (42), and the radiator (42) is located on an outer side of the first housing (41); and/or
the electrical structure (3) comprises a circuit board; and/or
the first housing (41) is made of an insulative material; and/or
the first housing (41) has an opening (412), a second housing (5) covers the opening (412), the first housing (41) is connected to the second housing (5) through at least one of a third engagement structure and a second connector, the second housing (5) is provided with a fifth hole configured to be connected to the second connector, and the fifth hole is any one of a through hole and a blind hole.

13. An electronic device, comprising an electrical structure (3), a to-be-connected structure (4), and the fixing connection assembly according to any one of claims 1 to 12, wherein
an insulating seat (11) of a limiting structure (1) of the fixing connection assembly is configured to be arranged at a second hole (31) of the electrical structure (3), and a first connector (2) of the fixing connection assembly is configured to pass through a third hole (43) of the to-be-connected structure (4), the second hole (31), and a first hole (112) of the insulating seat (11), the first connector (2) has one end connected to a limiting member (12) of the limiting structure (1) and the other end connected to the to-be-connected structure (4) at the third hole (43), so that a position of the electrical structure (3) relative to a position of the to-be-connected structure (4) is fixed; and
the to-be-connected structure (4) comprises a first housing (41), the electrical structure (3) is located in a mounting cavity (411) of the first housing (41), and at least an inner surface of the first housing (41) is insulated from the electrical structure (3).

14. An electric power system, comprising the fixing connection assembly according to any one of claims 1 to 12, or comprising the electronic device according to claim 13.
